# EUROPÄISCHE PATENTSCHRIFT

(11) **EP 3 220 136 B1**
(45) Veröffentlichungstag und Bekanntmachung des Hinweises auf die Patenterteilung: **06.03.2019**
(21) Anmeldenummer: 17153065.2
(22) Anmeldetag: 25.01.2017
(51) Int. Cl.: G01N 27/02, G01R 35/00

(54) **VERFAHREN ZUM BETREIBEN EINES INDUKTIVEN LEITFÄHIGKEITSSENSORS UND DIESBEZÜGLICHER INDUKTIVER LEITFÄHIGKEITSSENSOR**
METHOD FOR OPERATING AN INDUCTIVE CONDUCTIVITY SENSOR AND RELATED INDUCTIVE CONDUCTIVITY SENSOR
PROCÉDÉ DE FONCTIONNEMENT D'UN CAPTEUR DE CONDUCTIVITÉ INDUCTIVE ET CAPTEUR DE CONDUCTIVITÉ INDUCTIVE

(30) Priorität: 11.03.2016 DE 102016104549
(43) Veröffentlichungstag der Anmeldung: 20.09.2017
(73) Patentinhaber: Krohne Messtechnik GmbH, 47058 Duisburg (DE)
(72) Erfinder: Andelic, Edin, 58089 Hagen (DE)
(74) Vertreter: Gesthuysen Patent- und Rechtsanwälte

(56) Entgegenhaltungen:
- DE-A1-102007 054 910
- DE-A1-102009 026 998
- US-A- 3 389 332
- US-B1- 7 499 810

## Beschreibung

Die Erfindung betrifft zum einen ein Verfahren zum Betreiben eines induktiven Leitfähigkeitssensors. Der Leitfähigkeitssensor weist zur Durchführung des Verfahrens eine Sendespule und eine Empfangsspule auf und die Sendespule und die Empfangsspule sind durch ein elektrisch leitfähiges Medium induktiv miteinander gekoppelt. Bei dem Verfahren wird ein erstes elektrisches Sendesignal mit einer ersten Signalfrequenz erzeugt und der Sendespule zugeführt und ein erstes elektrisches Empfangssignal an der Sendespule gemessen. Unter Verwendung eines ersten Kalibriermodells für die erste Signalfrequenz wird aus dem ersten elektrischen Empfangssignal und dem ersten elektrischen Sendesignal eine erste Leitfähigkeit des Mediums bestimmt.

Die Erfindung betrifft zum anderen auch einen induktiven Leitfähigkeitssensor. Der Leitfähigkeitssensor weist eine Sendespule, eine Empfangsspule, einen Signalgenerator, eine Messeinrichtung und eine Steuerungseinrichtung auf. Der Signalgenerator ist zur Erzeugung von elektrischen Sendesignalen und zur Zuführung der Sendesignale zur Sendespule und die Messeinrichtung zur Messung von elektrischen Empfangssignalen an der Empfangsspule ausgebildet. Im Betrieb des Leitfähigkeitssensors sind die Sendespule und die Empfangsspule durch ein elektrisch leitfähiges Medium induktiv miteinander gekoppelt. Die Steuerungseinrichtung ist derart ausgebildet und steuert im Betrieb den Signalgenerator und die Messeinrichtung derart, dass der Signalgenerator ein erstes elektrisches Sendesignal mit einer ersten Signalfrequenz erzeugt und die Messeinrichtung ein erstes elektrisches Empfangssignal an der Empfangsspule misst. Die Steuerungseinrichtung bestimmt unter Verwendung eines ersten in der Steuerungseinrichtung hinterlegten Kalibriermodells für die erste Signalfrequenz aus dem ersten elektrischen Empfangssignal und dem ersten elektrischen Sendesignal eine erste Leitfähigkeit des Mediums.

Induktive Leitfähigkeitssensoren können auch in aggressiven und korrosiven Medien wie beispielsweise industriellen Abwässern, Meerwasser und sauren Lösungen verwendet werden, weil sowohl die Sendespule als auch die Empfangsspule nicht in unmittelbarem Kontakt mit einem Medium stehen müssen, sondern mit einem gegen aggressive und korrosive Medien resistenten Gehäuse umgeben sein können, ohne dass die Funktionsfähigkeit eines induktiven Leitfähigkeitssensors eingeschränkt ist. Da kein unmittelbarer Kontakt mit aggressiven und korrosiven Medien gegeben ist, zeichnen sich induktive Leitfähigkeitssensoren durch eine lange Lebensdauer und durch praktisch Wartungsfreiheit aus. Durch die Gehäuse sind sie darüber hinaus auch für hygienische Anwendungen in Prozessen der Branchen Lebensmittel, Getränke und Pharma geeignet.

Die Leitfähigkeit eines elektrisch leitfähigen Mediums wird durch einen induktiven Leitfähigkeitssensor bestimmt, indem zunächst ein elektrisches Sendesignal mit einer Signalfrequenz erzeugt und der Sendespule zugeführt wird. Das elektrische Sendesignal wird durch die Sendespule auf das Medium übertragen und das Medium überträgt das Sendesignal zur Empfangsspule. In der Empfangsspule induziert das durch das Medium übertragene Sendesignal ein Empfangssignal, welches gemessen wird. Die Größe des Empfangssignals in Bezug auf die Größe des Sendesignals ist ein Maß für die elektrische Leitfähigkeit des Mediums. Ein Kalibriermodell bestimmt entsprechend aus dem elektrischen Empfangssignal und dem elektrischen Sendesignal die Leitfähigkeit des Mediums. Ein Kalibriermodell beschreibt für eine Frequenz den Zusammenhang zwischen einerseits der elektrischen Leitfähigkeit eines Mediums und andererseits dem elektrischen Empfangssignal und dem elektrischen Sendesignal. Ein Kalibriermodell, das für eine andere Signalfrequenz als die zur Bestimmung der Leitfähigkeit des Mediums verwendete Signalfrequenz gilt, liefert Leitfähigkeiten, die von der tatsächlichen Leitfähigkeit des Mediums abweichen.

Leitfähigkeitsmessungen und dafür verwendbare Sensoren sind beispielsweise aus der DE102009026998A1, der US7499810 oder der DE102007054910A1 bekannt. Aus der Praxis ist bekannt, dass induktive Leitfähigkeitssensoren Defekte aufweisen können, die im Betrieb unerkannt bleiben und erst bei einer gesonderten Untersuchung erkannt werden.

Der Erfindung liegt daher die Aufgabe zugrunde, ein Verfahren zum Betreiben eines induktiven Leitfähigkeitssensors sowie einen induktiven Leitfähigkeitssensor anzugeben, bei dem Fehler im Betrieb erkannt und signalisiert werden.

Die Erfindung bezieht sich gemäß einer ersten Lehre auf ein Verfahren zum Betreiben eines induktiven Leitfähigkeitssensors, bei dem die hergeleitete und aufgezeigte Aufgabe gelöst ist. Das erfindungsgemäße Verfahren ist zunächst und im Wesentlichen durch die folgenden Verfahrensschritte gekennzeichnet, die sich an die aus dem Stand der Technik bekannten Verfahrensschritte zur Bestimmung der Leitfähigkeit des Mediums anschließen:
In einem ersten Verfahrensschritt wird mindestens ein weiteres elektrisches Sendesignal mit einer von der ersten Signalfrequenz verschiedenen weiteren Signalfrequenz erzeugt und der Sendespule zugeführt, ein weiteres elektrisches Empfangssignal an der Empfangsspule gemessen und unter Verwendung eines weiteren Kalibriermodells für die weitere Signalfrequenz aus dem weiteren elektrischen Empfangssignal und dem weiteren elektrischen Sendesignal eine weitere Leitfähigkeit des Mediums bestimmt. Jedes der weiteren elektrischen Sendesignale weist dabei eine von den übrigen Sendesignalen verschiedene Signalfrequenz auf und bedingt die Verwendung eines weiteren Kalibriermodells für gerade diese weitere Signalfrequenz. Wird das weitere Kalibriermodell für eine andere als diese weitere Signalfrequenz verwendet, so weicht die mit dem Kalibriermodell bestimmte Leitfähigkeit des Mediums von der tatsächlichen Leitfähigkeit des Mediums ab.

In einem zweiten Verfahrensschritt wird mindestens eine Leitfähigkeitsabweichung zwischen jeweils zwei der bestimmten Leitfähigkeiten des Mediums bestimmt. Die Leitfähigkeitsabweichung kann z. B. durch Subtraktion einer der bestimmten Leitfähigkeiten von einer anderen der bestimmten Leitfähigkeiten erfolgen. Es bietet sich an, dass jeweils zwei zeitlich aufeinanderfolgend bestimmte Leitfähigkeiten voneinander subtrahiert werden. Jede der Leitfähigkeitsabweichungen ist durch einen Betrag und ein Vorzeichen gekennzeichnet.

In einem dritten Verfahrensschritt wird die Leitfähigkeitsabweichung als ein Fehler signalisiert, wenn die mindestens eine Leitfähigkeitsabweichung eine Grenzleitfähigkeitsabweichung überschreitet. Die Grenzleitfähigkeitsabweichung ist eine von der jeweiligen Anwendung eines induktiven Leitfähigkeitssensors abhängige noch tolerierbare vorgebbare Leitfähigkeitsabweichung zwischen jeweils zwei der bestimmten Leitfähigkeiten des Mediums. Alternativ oder zusätzlich zur Signalisierung des Fehlers wird bei einer Überschreitung der Grenzleitfähigkeitsabweichung der induktive Leitfähigkeitssensor deaktiviert, so dass keine weiteren Bestimmungen der Leitfähigkeit des Mediums durchgeführt werden.

Das erfindungsgemäße Verfahren hat gegenüber aus dem Stand der Technik bekannten Verfahren den Vorteil, dass Fehler des induktiven Leitfähigkeitssensors im Betrieb erkannt und signalisiert werden.

Die Kalibriermodelle beschreiben das Verhältnis zwischen einerseits der elektrischen Leitfähigkeit des Mediums und andererseits zwischen den gemessenen Empfangssignalen und den erzeugten Sendesignalen, wobei für jede der Signalfrequenzen ein Kalibriermodell für diese Signalfrequenz verwendet wird. In einer ersten Ausgestaltung des erfindungsgemäßen Verfahrens ist vorgesehen, dass jedes der Kalibriermodelle die jeweilige Leitfähigkeit als eine Funktion eines Quotienten aus dem elektrischen Empfangssignal und dem elektrischen Sendesignal bestimmt. Dabei weist die jeweilige Funktion eine lineare Interpolation oder ein Polynom auf.

Die Erzeugung des ersten elektrischen Sendesignals und die Erzeugung des mindestens einen weiteren elektrischen Sendesignals können zeitlich verschieden zueinander angeordnet sein. In einer Ausgestaltung des erfindungsgemäßen Verfahrens ist vorgesehen, dass das erste elektrische Sendesignal und wenigstens das mindestens eine weitere elektrische Sendesignal gleichzeitig erzeugt werden. Die gleichzeitige Erzeugung der Sendesignale ermöglicht ein zeiteffizientes Verfahren. Die gleichzeitige Erzeugung der Sendesignale bewirkt auch eine gleichzeitige Messung des ersten Empfangssignals und wenigstens des mindestens einen weiteren Empfangssignals. Aufgrund der verschiedenen Signalfrequenzen der einzelnen Sendesignale sind auch die einzelnen Empfangssignale unterscheidbar, so dass die einzelnen Leitfähigkeiten des Mediums bestimmt werden können.

In einer zur vorstehenden Ausgestaltung alternativen Ausgestaltung ist vorgesehen, dass das erste elektrische Sendesignal und wenigstens das mindestens eine weitere elektrische Sendesignal zeitlich unmittelbar aufeinanderfolgend erzeugt werden. Die unmittelbar aufeinanderfolgende Erzeugung der Sendesignale bewirkt, dass das erste elektrische Empfangssignal und wenigstens das mindestens eine weitere elektrische Empfangssignal zeitlich unmittelbar aufeinanderfolgend an der Empfangsspule gemessen werden. Die zeitlich unmittelbar aufeinanderfolgende Erzeugung der Sendesignale und die zeitlich unmittelbar aufeinanderfolgende Messung der Empfangssignale bewirkt eine resourceneffiziente Implementierung des Verfahrens, da die Empfangssignale nicht gemäß ihrer Signalfrequenzen separiert werden müssen, sondern unmittelbar nacheinander ausgewertet werde können.

In einer weiteren Ausgestaltung des Verfahrens ist vorgesehen, dass mindestens zwei weitere elektrische Sendesignale erzeugt werden, wobei die Signalfrequenzen wenigstens des ersten elektrischen Signals und der mindestens zwei weiteren elektrischen Signale voneinander verschieden sind und dass mindestens zwei Leitfähigkeitsabweichungen zwischen jeweils zwei der bestimmten Leitfähigkeiten des Mediums bestimmt werden. Jedes der erzeugten elektrischen Sendesignale weist eine Signalfrequenz auf, die sich von den Signalfrequenzen der übrigen erzeugten elektrischen Sendesignale unterscheidet und wird der Sendespule zugeführt. Auch wird jedes von einem der Sendesignale erzeugte elektrische Empfangssignal an der Empfangsspule gemessen und unter Verwendung des Kalibriermodells für diese Signalfrequenz aus dem jeweiligen elektrischen Empfangssignal und dem jeweiligen elektrischen Sendesignal die Leitfähigkeit des Mediums bestimmt. Weiterhin wird eine Leitfähigkeitsabweichung zwischen jeweils zwei der bestimmten Leitfähigkeiten des Mediums bestimmt und, wenn mindestens einer der Leitfähigkeitsabweichungen die Grenzleitfähigkeitsabweichung überschreitet, diese Leitfähigkeitsabweichung als ein Fehler signalisiert.

Somit werden, wenn neben dem ersten elektrischen Sendesignal mindesten zwei weitere elektrische Sendesignale erzeugt werden, mindestens zwei Leitfähigkeitsabweichungen bestimmt, wobei jede der Leitfähigkeitsabweichungen einen Betrag und ein Vorzeichen aufweist. Es hat sich überraschenderweise gezeigt, dass anhand der Vorzeichen der bestimmten Leitfähigkeitsabweichungen auf bestimmte Fehler geschlossen werden kann. Deshalb ist in einer Weiterbildung der vorangehenden Ausgestaltung vorgesehen, dass die Vorzeichen der mindestens zwei Leitfähigkeitsabweichungen ausgewertet werden und dass uneinheitliche Vorzeichen als ein Fehler einer Mechanik des Leitfähigkeitssensors signalisiert werden. In einer zur vorangehenden Weiterbildung alternativen oder zusätzlichen Weiterbildung ist vorgesehen, dass die Vorzeichen der mindestens zwei Leitfähigkeitsabweichungen ausgewertet werden und das einheitliche Vorzeichen als ein Fehler der Kalibriermodelle signalisiert werden.

In einer Weiterbildung des erfindungsgemäßen Verfahrens ist darüber hinaus vorgesehen, dass das Verfahren mehrfach ausgeführt wird und die Häufigkeit der signalisierten Fehler signalisiert wird. Durch das mehrfache Ausführen des Verfahrens und die Signalisierung der Häufigkeit der Fehler werden fälschlicherweise signalisierte Fehler erkannt und werden in einer Ausgestaltung durch Voting kompensiert, wodurch das Verfahren in seiner Zuverlässigkeit verbessert wird.

Die Erfindung bezieht sich gemäß einer zweiten Lehre auf einen induktiven Leitfähigkeitssensor, bei dem die hergeleitete und aufgezeigte Aufgabe gelöst ist. Der erfindungsgemäße induktive Leitfähigkeitssensor ist zunächst und im Wesentlichen dadurch gekennzeichnet, dass die Steuerungseinrichtung zusätzlich derart ausgebildet ist und im Betrieb den Signalgenerator und die Messeinrichtung derart ansteuert, dass der Signalgenerator mindestens ein weiteres elektrisches Sendesignal mit einer von der ersten Signalfrequenz verschiedenen weiteren Signalfrequenz erzeugt, dass die Messeinrichtung ein weiteres elektrisches Empfangssignal an der Empfangsspule misst und die Steuerungseinrichtung unter Verwendung eines weiteren in der Steuerungseinrichtung hinterlegten Kalibriermodells für die weitere Signalfrequenz aus dem weiteren elektrischen Empfangssignal und dem weiteren elektrischen Sendesignal eine weitere Leitfähigkeit des Mediums bestimmt. Des Weiteren bestimmt die Steuerungseinrichtung mindestens eine Leitfähigkeitsabweichung zwischen jeweils zwei der bestimmten Leitfähigkeiten des Mediums und signalisiert, wenn die mindestens eine Leitfähigkeitsabweichung eine in der Steuerungseinrichtung hinterlegte Grenzleitfähigkeitsabweichung überschreitet, die Leitfähigkeitsabweichung als einen Fehler.

Eine Ausgestaltung des erfindungsgemäßen induktiven Leitfähigkeitssensors sieht vor, dass die Steuerungseinrichtung zur Ausführung eines der beschriebenen Verfahrens ausgebildet ist.

Die Ausführungen zu den Verfahren gelten entsprechend für den induktiven Leitfähigkeitssensor und umgekehrt.

Im Einzelnen ist eine Vielzahl von Möglichkeiten gegeben, das erfindungsgemäße Verfahren und das erfindungsgemäße Durchflussmessgerät auszugestalten und weiterzubilden. Dazu wird verwiesen sowohl auf die den Patentansprüchen 1 und 9 nachgeordneten Patentansprüche als auch auf die nachfolgende Beschreibung eines bevorzugten Ausführungsbeispiels in Verbindung mit der Zeichnung. In der Zeichnung zeigt
- Fig. 1: ein Ausführungsbeispiel eines induktiven Leitfähigkeitssensors und
- Fig. 2: einen Ablaufplan eines Ausführungsbeispiels eines Verfahrens.

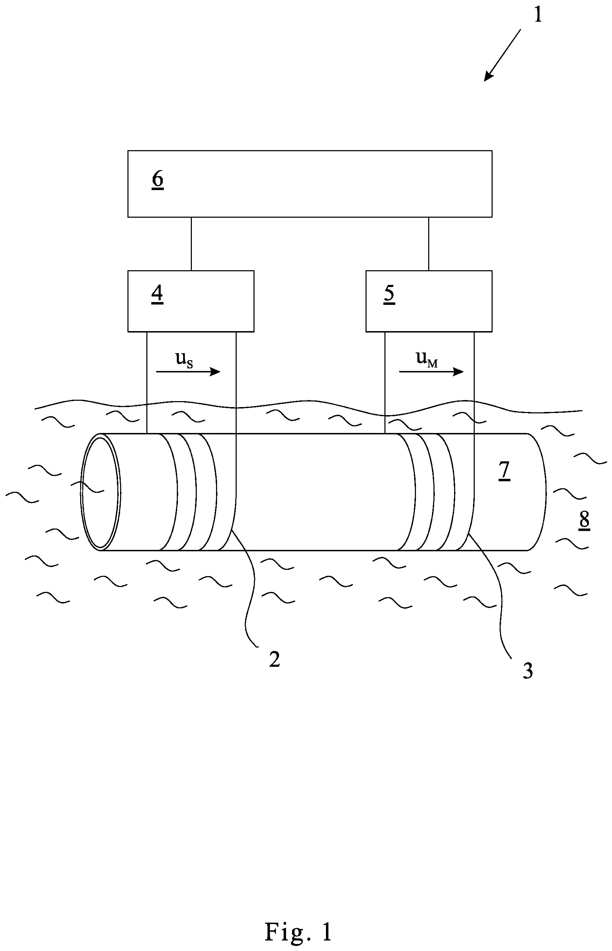

Fig. 1 zeigt den induktiven Leitfähigkeitssensor 1. Der Leitfähigkeitssensor 1 weist die Sendespule 2, die Empfangsspule 3, den Signalgenerator 4, die Messeinrichtung 5 und die Steuerungseinrichtung 6 auf. Die Sendespule 2 und die Empfangsspule 3 sind auf dem hohlzylinderförmigen Träger 7 angeordnet. Der induktive Leitfähigkeitssensor 1 ist im Betrieb und der Träger 7 mit der Sendespule 2 und der Empfangsspule 3 in das Medium 8 eingetaucht.

Das Medium 8 umgibt den Träger 7 und ist auch im Innenraum des Trägers 7. Das Medium 8 ist elektrisch leitfähig und koppelt dadurch die Sendespule 2 und die Empfangsspule 3 induktiv miteinander. In der Figur nicht dargestellt ist das Gehäuse, welches einen direkten Kontakt zwischen dem Leitfähigkeitssensor 1 und dem Medium 8 verhindert.

Der Signalgenerator 4 ist zur Erzeugung von elektrischen Sendesignalen us und Zuführung der Sendesignale u_{S} zur Sendespule 2 und die Messeinrichtung 5 zur Messung von elektrischen Empfangssignalen u_{M} an der Empfangsspule ausgebildet. Sowohl die elektrischen Sendesignale u_{S} als auch die elektrischen Empfangssignale u_{M} sind elektrische Wechselspannungen. Die Leitfähigkeit des elektrisch leitfähigen Mediums 8 wird durch den induktiven Leitfähigkeitssensor 1 bestimmt, indem zunächst ein elektrisches Sendesignal u_{S} mit einer Signalfrequenz erzeugt und der Sendespule zugeführt wird. Das elektrische Sendesignal wird durch die Sendespule 2 auf das Medium 8 übertragen und das Medium 8 überträgt das Sendesignal zur Empfangsspule 3. In der Empfangsspule 3 induziert das durch das Mediums 8 übertragene Sendesignal ein Empfangssignal u_{M}, welches von der Messeinrichtung 5 gemessen wird. Die Größe des Empfangssignals u_{M} in Bezug auf die Größe des Sendesignals u_{S} ist ein Maß für die elektrische Leitfähigkeit des Mediums 8. Ein in der Steuerungseinrichtung 6 hinterlegtes Kalibriermodell bestimmt entsprechend aus dem elektrischen Empfangssignal u_{M} und dem elektrischen Sendesignal u_{S} die Leitfähigkeit des Mediums 8. Das Kalibriermodell beschreibt für die Frequenz des Sendesignals u_{S} den Zusammenhang zwischen einerseits der elektrischen Leitfähigkeit des Mediums 8 und andererseits dem elektrischen Empfangssignal u_{M} und dem elektrischen Sendesignal u_{S}. Ein Kalibriermodell, das für eine andere Signalfrequenz als die zur Bestimmung der Leitfähigkeit des Mediums 8 verwendete Signalfrequenz gilt, liefert Leitfähigkeiten, die von der tatsächlichen Leitfähigkeit des Mediums 8 abweichen.

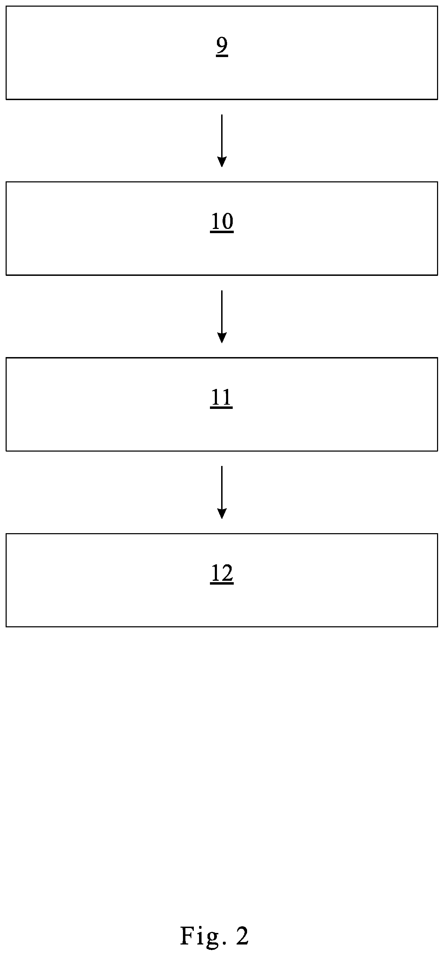

Da der induktive Leitfähigkeitssensor 1 im Betrieb ist, führt der Leitfähigkeitssensor 1 das im Ablaufplan in Fig. 2 dargestellte Verfahren mit den folgenden Verfahrensschritten aus.

In dem ersten Verfahrensschritt 9 steuert die Steuerungseinrichtung 6 den Signalgenerator 4 und die Messeinrichtung 5 derart, dass der Signalgenerator 4 ein erstes elektrisches Sendesignal u_{s,1} mit einer ersten Signalfrequenz erzeugt, die Messeinrichtung 5 ein erstes elektrisches Empfangssignal u_{M,1} an der Empfangsspule 3 misst und die Steuerungseinrichtung 6 unter Verwendung eines ersten in der Steuerungseinrichtung 6 hinterlegten Kalibriermodells für die erste Signalfrequenz aus dem ersten elektrischen Empfangssignal u_{M,1} und dem ersten elektrischen Sendesignal u_{S,1} eine erste Leitfähigkeit des Mediums bestimmt.

In dem zweiten Verfahrensschritt 10 steuert die Steuerungseinrichtung 6 den Signalgenerator 4 und die Messeinrichtung 5 derart an, dass der Signalgenerator 4 zeitlich unmittelbar auf das erste elektrische Sendesignal u_{s,1} folgend ein zweites elektrisches Sendesignal u_{S,2} mit einer von der ersten Signalfrequenz verschiedenen zweiten Signalfrequenz und zeitlich unmittelbar auf das zweite elektrische Sendesignal u_{S,2} folgend ein drittes elektrisches Sendesignal u_{S,3} mit einer von der ersten Signalfrequenz und der zweiten Signalfrequenz verschiedenen dritten Signalfrequenz erzeugt. Die Messeinrichtung 5 misst ein von dem zweiten Sendesignal u_{S,2} hervorgerufenes zweites elektrisches Empfangssignal u_{M,2} und ein von dem dritten Sendesignal u_{S,3} hervorgerufenes drittes elektrisches Empfangssignal u_{M,3}. Die Steuerungseinrichtung 6 bestimmt unter Verwendung eines zweiten in der Steuerungsreinrichtung 6 hinterlegten Kalibriermodells für die zweite Signalfrequenz aus dem zweiten elektrischen Empfangssignal u_{M,2} und dem zweiten elektrischen Sendesignal u_{S,2} eine zweite Leitfähigkeit des Mediums und unter Verwendung eines dritten in der Steuerungseinrichtung 6 hinterlegten Kalibriermodells für die dritte Signalfrequenz aus dem dritten elektrischen Empfangssignal u_{M,3} und dem dritten elektrischen Sendesignal u_{S,2} eine dritte Leitfähigkeit des Mediums.

Jedes der drei Kalibriermodelle beschreibt jeweils für eine der drei Frequenzen den Zusammenhang zwischen einerseits der elektrischen Leitfähigkeit des Mediums 8 und andererseits dem jeweiligen elektrischen Empfangssignal u_{M} und dem jeweiligen elektrischen Sendesignal u_{S}. Ein Kalibriermodell, das für eine andere Signalfrequenz als die zur Bestimmung der Leitfähigkeit des Mediums verwendete Signalfrequenz bestimmt worden ist, liefert Leitfähigkeiten, die von der tatsächlichen Leitfähigkeit des Mediums 8 abweichen.

Für jedes der drei Kalibriermodelle gilt, dass die Leitfähigkeit als jeweils eine Funktion eines Quotienten aus dem elektrischen Empfangssignal u_{M} und dem elektrischen Sendesignal u_{S} bestimmt wird. Dabei weist die jeweilige Funktion ein Polynom auf. Somit ist das Polynom eine Funktion des Quotienten.

In dem dritten Verfahrensschritt 11 bestimmt die Steuerungseinrichtung 6 eine erste Leitfähigkeitsabweichung zwischen der dritten Leitfähigkeit und der zweiten Leitfähigkeit und eine zweite Leitfähigkeitsabweichung zwischen der zweiten Leitfähigkeit und der ersten Leitfähigkeit des Mediums 8. Die Leitfähigkeitsabweichungen werden somit jeweils zwischen zwei zeitlich aufeinanderfolgend bestimmten Leitfähigkeiten des Mediums 8 bestimmt.

In dem vierten Verfahrensschritt 12 signalisiert die Steuerungseinrichtung 6, wenn mindestens eine der zwei Leitfähigkeitsabweichungen eine in der Steuerungseinrichtung 6 hinterlegte Grenzleitfähigkeitsabweichung überschreitet, diese Leitfähigkeitsabweichung als einen Fehler. Die Grenzleitfähigkeitsabweichung ist eine von der Anwendung des induktiven Leitfähigkeitssensors 1 abhängige noch tolerierbare vorgegebene Leitfähigkeitsabweichung zwischen jeweils zwei der bestimmten Leitfähigkeiten des Mediums 8.

### Bezugszeichen

- 1: Leitfähigkeitssensor
- 2: Sendespule
- 3: Empfangsspule
- 4: Signalgenerator
- 5: Messeinrichtung
- 6: Steuerungseinrichtung
- 7: Träger
- 8: Medium
- 9: Erster Verfahrensschritt
- 10: Zweiter Verfahrensschritt
- 11: Dritter Verfahrensschritt
- 12: Vierter Verfahrensschritt

- u_{S}, u_{S,i}: Sendesignal, u_{S} umfasst alle u_{S,i}
- u_{M}, u_{M,i}: Empfangssignal, u_{M} umfasst alle u_{M,i}
- i: Natürliche Zahl als Laufindex zur Unterscheidung der einzelnen Sendesignale und Empfangssignale untereinander.

## Patentansprüche

1. Verfahren zum Betreiben eines induktiven Leitfähigkeitssensors (1), wobei der Leitfähigkeitssensor (1) eine Sendespule (2) und eine Empfangsspule (3) aufweist und die Sendespule (2) und die Empfangsspule (3) durch ein elektrisch leitfähiges Medium (8) induktiv miteinander gekoppelt sind,
wobei ein erstes elektrisches Sendesignal (u_{S,1}) mit einer ersten Signalfrequenz erzeugt und der Sendespule (2) zugeführt wird, ein erstes elektrisches Empfangssignal (u_{M,1}) an der Empfangsspule (3) gemessen wird und unter Verwendung eines ersten Kalibriermodells für die erste Signalfrequenz aus dem ersten elektrischen Empfangssignal (u_{M,1}) und dem ersten elektrischen Sendesignal (u_{S,1}) eine erste Leitfähigkeit des Mediums (8) bestimmt wird,
**dadurch gekennzeichnet,**
**dass** mindestens ein weiteres elektrisches Sendesignal (u_{S,2}) mit einer von der ersten Signalfrequenz verschiedenen weiteren Signalfrequenz erzeugt und der Sendespule (2) zugeführt wird, dass ein weiteres elektrisches Empfangssignal (u_{M,2}) an der Empfangsspule (3) gemessen wird und unter Verwendung eines weiteren Kalibriermodells für die weitere Signalfrequenz aus dem weiteren elektrischen Empfangssignal (u_{M,2}) und dem weiteren elektrischen Sendesignal (u_{S,2}) eine weitere Leitfähigkeit des Mediums (8) bestimmt wird,
**dass** mindestens eine Leitfähigkeitsabweichung zwischen jeweils zwei der bestimmten Leitfähigkeiten des Mediums (8) bestimmt wird und
**dass**, wenn die mindestens eine Leitfähigkeitsabweichung eine Grenzleitfähigkeitsabweichung überschreitet, die Leitfähigkeitsabweichung als ein Fehler signalisiert wird.

2. Verfahren nach Anspruch 1, **dadurch gekennzeichnet, dass** jedes der Kalibriermodelle die jeweilige Leitfähigkeit als jeweils eine Funktion eines Quotienten aus dem elektrischen Empfangssignal (u_{M}) und dem elektrischen Sendesignal (u_{S}) bestimmt, wobei die jeweilige Funktion eine lineare Interpolation oder ein Polynom aufweist.

3. Verfahren nach Anspruch 1 oder 2, **dadurch gekennzeichnet, dass** das erste elektrische Sendesignal (u_{S,1}) und wenigstens das mindestens eine weitere elektrische Sendesignal (u_{S,2}) gleichzeitig erzeugt werden.

4. Verfahren nach Anspruch 1 oder 2, **dadurch gekennzeichnet, dass** das erste elektrische Sendesignal (u_{S,1}) und wenigstens das mindestens eine weitere elektrische Sendesignal (u_{S,2}) zeitlich unmittelbar aufeinanderfolgend erzeugt werden.

5. Verfahren nach einem der Ansprüche 1 bis 4, **dadurch gekennzeichnet, dass** mindestens zwei weitere elektrische Sendesignale (u_{S,2}, u_{S,3}) erzeugt werden, wobei die Signalfrequenzen wenigstens des ersten elektrischen Signals (u_{S,1}) und der mindestens zwei weiteren elektrischen Sendesignale (u_{S,2}, u_{S,3}) voneinander verschieden sind und dass mindestens zwei Leitfähigkeitsabweichungen zwischen jeweils zwei der bestimmten Leitfähigkeiten des Mediums (8) bestimmt werden.

6. Verfahren nach Anspruch 5, **dadurch gekennzeichnet, dass** die Vorzeichen der mindestens zwei Leitfähigkeitsabweichungen ausgewertet werden und dass einheitliche Vorzeichen als ein Fehler der Kalibriermodelle signalisiert werden.

7. Verfahren nach Anspruch 5 oder 6, **dadurch gekennzeichnet, dass** die Vorzeichen der mindestens zwei Leitfähigkeitsabweichungen ausgewertet werden und dass uneinheitliche Vorzeichen als ein Fehler einer Mechanik des Leitfähigkeitssensors (1) signalisiert werden.

8. Verfahren zum Betreiben eines induktiven Leitfähigkeitssensors (1), **dadurch gekennzeichnet, dass** das Verfahren nach einem der Ansprüche 1 bis 7 mehrfach ausgeführt wird und die Häufigkeit der signalisierten Fehler signalisiert wird.

9. Induktiver Leitfähigkeitssensor (1), mit einer Sendespule (2), einer Empfangsspule (3), einem Signalgenerator (4), einer Messeinrichtung (5) und einer Steuerungseinrichtung (6),
wobei der Signalgenerator (4) zur Erzeugung von elektrischen Sendesignalen (us) und Zuführung der Sendesignale (u_{S}) zur Sendespule (2) und die Messeinrichtung (5) zur Messung von elektrischen Empfangssignalen (u_{M}) an der Empfangsspule (3) ausgebildet sind,
wobei im Betrieb des Leitfähigkeitssensors (1) die Sendespule (2) und die Empfangsspule (3) durch ein elektrisch leitfähiges Medium (8) induktiv miteinander gekoppelt sind,
wobei die Steuerungseinrichtung (6) derart ausgebildet ist und im Betrieb den Signalgenerator (4) und die Messeinrichtung (5) derart steuert, dass der Signalgenerator (4) ein erstes elektrisches Sendesignal (u_{S,1}) mit einer ersten Signalfrequenz erzeugt, die Messeinrichtung (5) ein erstes elektrisches Empfangssignal (u_{M,1}) an der Empfangsspule (3) misst und die Steuerungseinrichtung (6) unter Verwendung eines ersten in der Steuerungseinrichtung (6) hinterlegten Kalibriermodells für die erste Signalfrequenz aus dem ersten elektrischen Empfangssignal (u_{M,1}) und dem ersten elektrischen Sendesignal (u_{S,1}) eine erste Leitfähigkeit des Mediums (8) bestimmt,
**dadurch gekennzeichnet,**
**dass** die Steuerungseinrichtung (6) zusätzlich derart ausgebildet ist und im Betrieb den Signalgenerator (4) und die Messeinrichtung (5) derart ansteuert,
**dass** der Signalgenerator (4) mindestens ein weiteres elektrisches Sendesignal (u_{S,2}) mit einer von der ersten Signalfrequenz verschiedenen weiteren Signalfrequenz erzeugt, dass die Messeinrichtung (5) ein weiteres elektrisches Empfangssignal (u_{M,2}) an der Empfangsspule (3) misst und die Steuerungseinrichtung (6) unter Verwendung eines weiteren in der Steuerungseinrichtung (6) hinterlegten Kalibriermodells für die weitere Signalfrequenz aus dem weiteren elektrischen Empfangssignal (u_{M,2}) und dem weiteren elektrischen Sendesignal (u_{S,2}) eine weitere Leitfähigkeit des Mediums (8) bestimmt,
**dass** die Steuerungseinrichtung (6) mindestens eine Leitfähigkeitsabweichung zwischen jeweils zwei der bestimmten Leitfähigkeiten des Mediums (8) bestimmt und
**dass** die Steuerungseinrichtung (6), wenn die mindestens eine Leitfähigkeitsabweichung eine in der Steuerungseinrichtung (6) hinterlegte Grenzleitfähigkeitsabweichung überschreitet, die Leitfähigkeitsabweichung als einen Fehler signalisiert.

10. Induktiver Leitfähigkeitssensor (1) nach Anspruch 9, **dadurch gekennzeichnet, dass** die Steuerungseinrichtung (6) zur Ausführung eines Verfahrens nach einem der Ansprüche 1 bis 8 ausgebildet ist.

## Claims

1. Method for operating an inductive conductivity sensor (1),
wherein the conductivity sensor (1) has a transmit coil (2) and a receive coil (3), and the transmit coil (2) and the receive coil (3) are inductively coupled to one another by an electrically conductive medium (8),
wherein a first electrical transmit signal (u_{S,1}) is generated at a first signal frequency and fed to the transmit coil (2), a first electrical receive signal (u_{M,1}) is measured at the receive coil (3) and a first conductivity of the medium (8) is determined from the first electrical receive signal (u_{M,1}) and the first electrical transmit signal (u_{S,1}) using a first calibration model for the first signal frequency,
**characterized in**
**that** at least one further electrical transmit signal (u_{S,2}) is generated at a further signal frequency different from the first signal frequency and fed to the transmit coil (2), that a further electrical receive signal (u_{M,2}) is measured at the receive coil (3) and a further conductivity of the medium (8) is determined from the further electrical receive signal (u_{M,2}) and the further electrical transmit signal (u_{S,2}) using a further calibration model for the further signal frequency,
**that** at least one conductivity difference is determined between respectively two of the determined conductivities of the medium (8) and
**that**, if the at least one conductivity difference exceeds a threshold conductivity difference, the conductivity difference is signaled as an error.

2. Method according to claim 1, **characterized in that** each of the calibration models determines the respective conductivity as a respective function of a quotient of the electrical receive signal (u_{M}) and the electrical transmit signal (u_{S}), wherein the respective function comprises a linear interpolation or a polynomial.

3. Method according to claim 1 or 2, **characterized in that** the first electrical transmit signal (u_{S,1}) and at least the at least one further electrical transmit signal (u_{S,2}) are generated simultaneously.

4. Method according to claim 1 or 2, **characterized in that** the first electrical transmit signal (u_{S,1}) and at least the at least one further electrical transmit signal (u_{S,2}) are generated in direct succession with respect to time.

5. Method according to any one of claims 1 to 4, **characterized in that** at least two further electrical transmit signals (u_{S,2}, u_{S,3}) are generated, wherein the signal frequencies of at least the first electrical signal (u_{S,1}) and the at least two further electrical transmit signals (u_{S,2}, u_{S,3}) are different from one another, and that at least two conductivity differences are determined between respectively two of the determined conductivities of the medium (8).

6. Method according to claim 5, **characterized in that** the algebraic signs of the at least two conductivity differences are evaluated and that uniform signs are signaled as an error of the calibration models.

7. Method according to claim 5 or 6, **characterized in that** the algebraic signs of the at least two conductivity differences are evaluated and that nonuniform signs are signaled as an error of a mechanism of the conductivity sensor (1).

8. Method for operating an inductive conductivity sensor (1), **characterized in that** the method is carried out several times according to any one of claims 1 to 7 and the frequency of occurrence of the signaled errors is signaled.

9. Inductive conductivity sensor (1), having a transmit coil (2), a receive coil (3), a signal generator (4), a measuring device (5) and a control device (6),
wherein the signal generator (4) is designed for generating electrical transmit signals (u_{S}) and feeding the transmit signals (u_{S}) to the transmit coil (2), and the measuring device (5) is designed for measuring electrical receive signals (u_{M}) at the receive coil (3),
wherein the transmit coil (2) and the receive coil (3) are inductively coupled to one another by an electrically conductive medium (8) during operation of the conductivity sensor (1),
wherein the control device (6) is designed such and controls the signal generator (4) and the measuring device (5) during operation such that the signal generator (4) generates a first electrical transmit signal (u_{S,1}) at a first signal frequency, the measuring device (5) generates a first electrical receive signal (u_{M,1}) at the receive coil (3) and the control device (6) determines a first conductivity of the medium (8) from the first electrical receive signal (u_{M,1}) and the first electrical transmit signal (u_{S,1}) using a first calibration model for the first signal frequency stored in the control device (6),
**characterized in**
**that** the control device (6) is additionally designed such and controls the signal generator (4) and the measuring device (5) during operation such
**that** the signal generator (4) generates at least one further electrical transmit signal (u_{S,2}) at a further signal frequency different from the first signal frequency, that the measuring device (5) measures a further electrical receive signal (u_{M,2}) at the receive coil (3), and the control device (6) determines a further conductivity of the medium (8) from the further electrical receive signal (u_{M,2}) and the further electrical transmit signal (u_{S,2}) using a further calibration model stored in the control device (6) for the further signal frequency,
**that** the control device (6) determines at least one conductivity difference between respectively two of the determined conductivities of the medium (8), and
**that**, if the at least one conductivity difference exceeds a threshold conductivity difference stored in the control device (6), the control device (6) signals the conductivity difference as an error.

10. Inductive conductivity sensor (1) according to claim 9, **characterized in that** the control device (6) is designed to carry out a method according to any one of claims 1 to 8.

## Revendications

1. Procédé de fonctionnement d'un capteur de conductivité inductive (1) ;
le capteur de conductivité (1) comportant une bobine émettrice (2) et une bobine réceptrice (3) et la bobine émettrice (2) et la bobine réceptrice (3) étant couplées entre elles de façon inductive par le biais d'un support électriquement conducteur (8) ;
un premier signal d'émission électrique (u_{S,1}) étant produit à une première fréquence de signal et étant amené à la bobine émettrice (2), un premier signal de réception électrique (u_{M,1}) étant mesuré au niveau de la bobine réceptrice (3) et une première conductivité du support (8) étant déterminée en utilisant un premier modèle d'étalonnage pour la première fréquence de signal à partir du premier signal de réception électrique (u_{M,1}) et du premier signal d'émission électrique (u_{S,1}) ;
**caractérisé en ce que** :
au moins un signal d'émission électrique (u_{S,2}) supplémentaire est produit à une fréquence de signal supplémentaire différente de la première fréquence de signal et amené à la bobine émettrice (2), qu'un signal de réception électrique (u_{M,2}) supplémentaire est mesuré au niveau de la bobine réceptrice (3) et qu'une conductivité supplémentaire du support (8) est déterminée en utilisant un modèle d'étalonnage supplémentaire pour la fréquence de signal supplémentaire à partir du signal de réception électrique (u_{M,2}) supplémentaire et du signal d'émission électrique (u_{S,2}) supplémentaire ;
au moins un écart de conductivité est déterminé entre respectivement deux des conductivités déterminées du support (8) ; et
lorsque l'au moins un écart de conductivité dépasse un écart de conductivité limite, l'écart de conductivité est signalé comme une erreur.

2. Procédé selon la revendication 1, **caractérisé en ce que** chacun des modèles d'étalonnage détermine la conductivité respective sous la forme respectivement d'une fonction d'un quotient à partir du signal de réception électrique (u_{M}) et du signal d'émission électrique (u_{S}), la fonction respective comportant une interpolation linéaire ou un polynôme.

3. Procédé selon la revendication 1 ou 2, **caractérisé en ce que** le premier signal d'émission électrique (u_{S,1}) et au moins l'au moins un signal d'émission électrique (u_{S,2}) supplémentaire sont produits simultanément.

4. Procédé selon la revendication 1 ou 2, **caractérisé en ce que** le premier signal d'émission électrique (u_{S,1}) et au moins l'au moins un signal d'émission électrique (u_{S,2}) supplémentaire sont produits directement à la suite l'un de l'autre dans le temps.

5. Procédé selon l'une quelconque des revendications 1 à 4, **caractérisé en ce qu'**au moins deux signaux d'émission électriques (u_{S,2}, u_{S,3}) supplémentaires sont produits, les fréquences de signal du premier signal électrique (u_{S,1}) au moins et des au moins deux signaux d'émission électriques (u_{S,2}, u_{S,3}) supplémentaires étant différentes les unes des autres et au moins deux écarts de conductivité étant déterminés entre respectivement deux des conductivités déterminées du support (8).

6. Procédé selon la revendication 5, **caractérisé en ce que** les signes des au moins deux écarts de conductivité sont évalués et que des signes homogènes sont signalés comme une erreur des modèles d'étalonnage.

7. Procédé selon la revendication 5 ou 6, **caractérisé en ce que** les signes des au moins deux écarts de conductivité sont analysés et que des signes homogènes sont signalés comme une erreur d'un mécanisme du capteur de conductivité (1).

8. Procédé de fonctionnement d'un capteur de conductivité inductive (1), **caractérisé en ce que** le procédé selon l'une quelconque des revendications 1 à 7 est réalisé de multiples fois et que la fréquence de l'erreur signalée est signalée.

9. Capteur de conductivité inductive (1), avec une bobine émettrice (2), une bobine réceptrice (3), un générateur de signal (4), un dispositif de mesure (5) et un dispositif de commande (6) ;
le générateur de signal (4) étant réalisé pour produire des signaux d'émission électriques (u_{S}) et amener les signaux d'émission (u_{S}) à la bobine émettrice (2) et au dispositif de mesure (5) en vue de mesurer les signaux électriques de réception (u_{M}) au niveau de la bobine réceptrice (3) ;
en situation de fonctionnement du capteur de conductivité (1), la bobine émettrice (2) et la bobine réceptrice (3) étant couplées entre elles de façon inductive par le biais d'un support électriquement conducteur (8) ;
le dispositif de commande (6) étant réalisé de telle sorte et commandant de telle sorte en situation de fonctionnement le générateur de signal (4) et le dispositif de mesure (5) que le générateur de signal (4) produise un premier signal d'émission électrique (u_{S,1}) à une première fréquence de signal, que le dispositif de mesure (5) mesure un premier signal de réception électrique (u_{M,1}) au niveau de la bobine réceptrice (3) et que le dispositif de commande (6) détermine, en utilisant un premier modèle d'étalonnage mémorisé dans le dispositif de commande (6), une première conductivité du support (8) pour la première fréquence de signal à partir du premier signal de réception électrique (u_{M,1}) et du premier signal d'émission électrique (u_{S,1}) ;
**caractérisé en ce que** :
le dispositif de commande (6) est en outre réalisé de telle sorte et commande de telle sorte en fonctionnement le générateur de signal (4) et le dispositif de mesure (5) que :
le générateur de signal (4) produise au moins un signal d'émission électrique (u_{S,2}) supplémentaire à une fréquence de signal supplémentaire différente de la première fréquence de signal, que le dispositif de mesure (5) mesure un signal de réception électrique (u_{M,2}) supplémentaire au niveau de la bobine réceptrice (3) et que le dispositif de commande (6) détermine, en utilisant un modèle d'étalonnage supplémentaire mémorisé dans le dispositif de commande (6), une conductivité supplémentaire du support (8) pour la fréquence de signal supplémentaire à partir du signal de réception électrique (u_{M,2}) supplémentaire et du signal d'émission électrique (u_{S,2}) supplémentaire ;
que le dispositif de commande (6) détermine au moins un écart de conductivité entre respectivement deux des conductivités déterminées du support (8) ; et
que le dispositif de commande (6) signale l'écart de conductivité comme une erreur lorsque l'au moins un écart de conductivité dépasse un écart de conductivité limite mémorisé dans le dispositif de commande (6).

10. Capteur de conductivité inductive (1) selon la revendication 9, **caractérisé en ce que** le dispositif de commande (6) est réalisé pour la mise en oeuvre d'un procédé selon l'une quelconque des revendications 1 à 8.
